# FASCICULE DE BREVET EUROPEEN

(11) **EP 0 612 206 B1**
(45) Date de publication et mention de la délivrance du brevet: **20.03.1996**
(21) Numéro de dépôt: 94400316.9
(22) Date de dépôt: 14.02.1994
(51) Int. Cl.: H05K 9/00

(54) **Système de connexion électrique de masse entre une embase coaxiale et une semelle d'un circuit hyperfréquence et dispositif de liaison électrique utilisé dans un tel système**
Elektrisches Masseverbindungssystem zwischen einer koaxialen Steckverbindung und der Platte einer hyperfrequenten Schaltung und elektrische Verbindungsvorrichtung für dieses System
Electric ground connection system between a coaxial connector and a plate of a hyperfrequency circuit and electric connection device for such a system

(30) Priorité: 16.02.1993 FR 9301709
(43) Date de publication de la demande: 24.08.1994
(73) Titulaire: ALCATEL TELSPACE, F-92734 Nanterre Cédex (FR)
(72) Inventeur: Bernaud, Maurice, F-92600 Asnières (FR); Maquet, Freddy, F-92200 Neuilly sur Seine (FR)
(74) Mandataire: Pothet, Jean Rémy Emile Ludovic

(56) Documents cités:
- EP-A- 0 003 133
- EP-A- 0 429 037
- DE-U- 6 931 004
- GB-A- 2 181 607

## Description

Le domaine de l'invention est celui des systèmes de contact électrique entre une fiche ou encore embase coaxiale et une semelle d'un circuit hyperfréquence compris dans un boîtier de blindage.

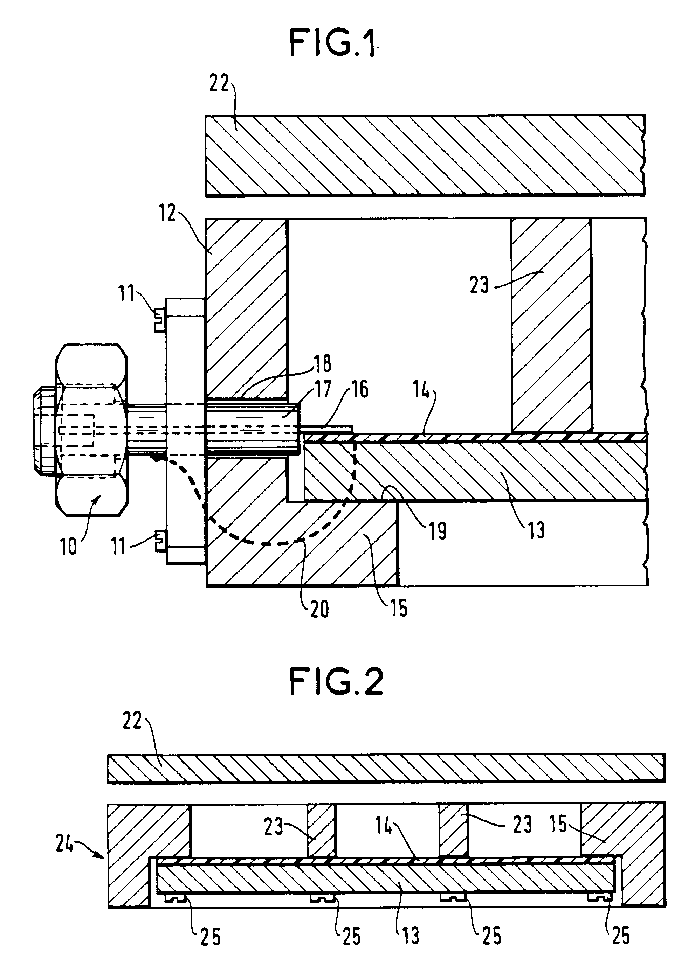

De façon connue, un circuit électronique destiné à fonctionner à des fréquences importantes peut être réalisé sur un substrat, par exemple en verre-Téflon, lui-même monté sur une semelle conductrice, par exemple en laiton. Un tel circuit est ensuite enfermé dans un boîtier de blindage électromagnétique et sa connexion électrique avec les appareils environnants est assuré à l'aide d'embases coaxiales fixées à l'extérieur du boîtier, comme représenté sur la figure 1 qui est une vue en coupe partielle d'un contact électrique entre une embase et un circuit électronique.

Une embase 10 est fixée, à l'aide de vis 11, contre une paroi latérale 12 d'un socle de boîtier de blindage électromagnétique. Le socle, à l'intérieur duquel est fixé un circuit hyperfréquence comprenant une semelle 13 conductrice et un substrat 14, comporte un trottoir 15 sur tout son périmètre et coopère avec un couvercle 22 pour former le boîtier. La semelle 13 surmontée du substrat 14 est fixée, à l'aide de vis non représentées, contre ce trottoir 15, servant ainsi de support.

L'âme 16 de l'embase 10 est partiellement entourée d'une gaine isolante 17, par exemple en Téflon, et est engagée dans un logement 18 qui traverse la paroi 12 de part en part. Après vissage de l'embase 10 contre la paroi 12, l'extrémité de l'âme 16 est soudée sur le substrat 14.

Le principal inconvénient de ce système de connexion électrique est que le contact de masse à assurer entre la semelle 13 et le corps de l'embase 10 est réalisé par l'intermédiaire du trottoir 15 et de l'interface 19 située entre ce trottoir 15 et la semelle 13. Le chemin de masse, représente en traits discontinus et référencé 20, est long et suppose un excellent contact au niveau de l'interface 19.

On observe fréquemment une absorption des ondes hyperfréquence lorsque le contact de masse est établi de cette manière là, notamment aux fréquences importantes, supérieures à quelques GHz.

Un autre inconvénient de ce système de connexion est que des cloisons de séparation individuelles, telles que 23, doivent être utilisées lorsqu'on désire séparer des fonctions hyperfréquence. Chaque cloison de séparation 23 doit alors être vissée sur le substrat 14 et munie, à son extrémité située du côté du couvercle 22, d'un joint hyperfréquence car il existe forcément un jeu entre le couvercle 22 et le haut des cloisons. Le nombre de pièces nécessaires à la réalisation de la fonction hyperfréquence est donc important, puisque les cloisons 23 ne peuvent pas faire partie du couvercle 22 ou du socle.

Pour résoudre ce dernier inconvénient, la fixation du circuit hyperfréquence, comprenant le substrat sur semelle conductrice, peut être réalisée conformément à la figure 2.

Le circuit hyperfréquence est vissé par le dessous, par les vis 25, c'est à dire que le substrat 14 repose contre le trottoir 15. Il est ainsi possible de diminuer le nombre de pièces mécaniques mises en jeu puisque le boîtier de blindage n'est plus constitué que par un socle 24 et le couvercle 22. Les cloisons de séparation 23 font partie intégrante du socle 24.

Cependant, ce type d'assemblage fait que la semelle 13 n'est plus en contact électrique avec la masse du boîtier, comme précédemment. Ce contact ne peut être ramené qu'indirectement, par exemple par des trous métallisés situés de part et d'autre de la ligne microstrip d'accès du circuit hyperfréquence; ils sont alors inefficaces en hyperfréquence car trop éloignés de cette ligne d'accès.

La présente invention a notamment pour objectif de pallier ces multiples inconvénients.

Plus précisément, un des objectifs de l'invention est de fournir un système de liaison électrique de masse entre d'une part une semelle conductrice d'un circuit hyperfréquence, compris dans un boîtier de blindage électromagnétique, et d'autre part une embase de connexion fixée à l'extérieur de ce boîtier.

Un autre objectif est de fournir une embase permettant de réaliser une telle liaison électrique de masse.

Ces objectifs, ainsi que d'autres qui apparaîtront par la suite, sont atteints grâce à système de liaison électrique entre un circuit électronique réalisé sur un substrat sur semelle conductrice d'électricité fixé dans un boîtier de blindage électromagnétique et une embase coaxiale fixée contre une paroi externe de ce boîtier de blindage, l'âme de l'embase étant engagée dans un logement de la paroi pour être reliée au circuit électronique, l'embase présentant une surface de masse située en face de ladite paroi. Selon l'invention, le contact de masse entre l'embase et la semelle est réalisé par l'intermédiaire d'une bague conductrice d'électricité disposée coaxialement par rapport à l'âme, isolée de cette âme et simultanément en contact électrique avec la surface de masse de l'embase et la semelle lorsque l'embase est fixée contre la paroi du boîtier.

On assure ainsi une continuité de masse entre l'embase et la semelle du circuit électronique.

Dans un mode de réalisation avantageux, la bague coopère avec une rondelle élastique conductrice d'électricité disposée coaxialement par rapport à l'âme de l'embase, entre la surface de masse et la bague.

La bague utilisée peut présenter une élasticité. A cet égard, elle peut être en un matériau synthétique chargé de métal.

Dans un autre mode de réalisation, pouvant être complémentaire du précédent, l'embase coaxiale est fixée à l'aide de vis contre la paroi du boîtier et chacune des vis coopère avec une rondelle élastique.

De manière générale, l'utilisation d'éléments élastiques tels que des rondelles permet de tenir compte à la fois des déformations des matériaux employés, par exemple suite à un changement de température entraînant une dilatation, et des tolérances d'usinage.

Dans une application préférentielle, le boîtier présente un trottoir contre lequel est fixé le substrat, le trottoir présentant une échancrure au niveau du logement de la paroi pour permettre l'accès à la ligne microstrip d'accès du circuit électronique.

Il est ainsi possible de réaliser des contacts de masse performants pour des circuits compris dans des boîtiers tel que représenté à la figure 2.

Avantageusement, la bague présente un méplat destiné à être soudé sur la semelle du circuit électronique. On améliore ainsi encore le contact de masse.

L'invention concerne également un dispositif de liaison électrique, pour utilisation dans le système de liaison électrique décrit ci-dessus, du type constitué par une embase coaxiale présentant une âme et une surface de masse, ce dispositif comprenant une bague conductrice d'électricité isolée de l'âme et disposée coaxialement par rapport à cette âme.

D'autres caractéristiques et avantages de l'invention apparaîtront à la lecture de la description suivante de plusieurs modes de réalisation préférentiels, donnés à titre illustratif et non limitatif, et des dessins annexés dans lesquels:
- la figure 1 est une vue en coupe partielle d'un contact électrique entre une embase et un circuit électronique compris dans un boîtier de blindage;
- la figure 2 est une vue schématique d'un mode de fixation avantageux d'un circuit électronique dans un boîtier de blindage;
- la figure 3 est une vue en coupe partielle d'un premier mode de réalisation préférentiel de l'invention;
- la figure 4 est une vue de l'arrière d'une embase utilisée dans la présente invention;
- la figure 5 représente un deuxième mode de réalisation préférentiel de l'invention;
- la figure 6 représente un troisième mode de réalisation préférentiel de l'invention;
- la figure 7 est une vue de dessus d'un socle muni du dispositif de liaison électrique de l'invention;
- la figure 8 est une vue en coupe d'un autre mode de réalisation d'une bague.

Les figures 1 et 2 ont été décrites précédemment en référence à l'état de la technique.

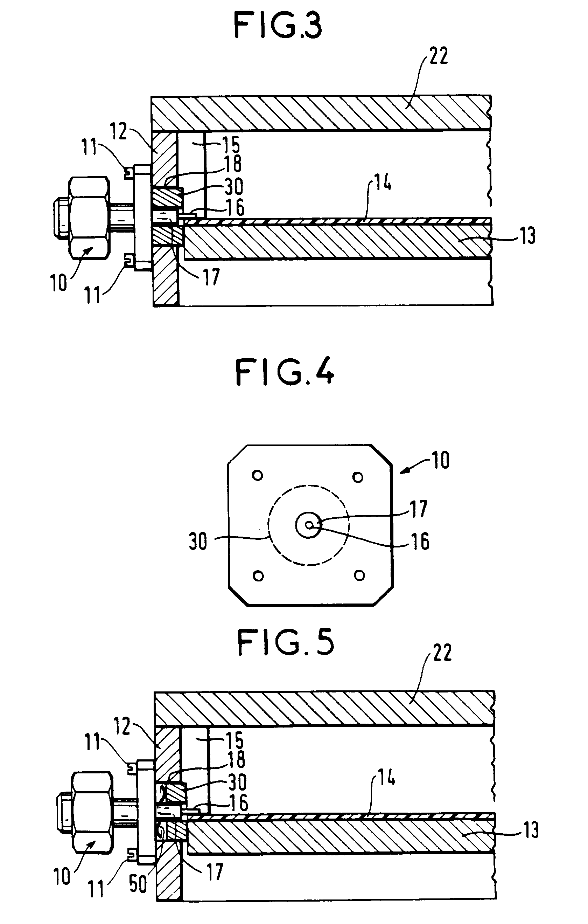

Sur la figure 3 est représenté un premier mode de réalisation préférentiel de l'invention.

Le circuit électronique réalisé sur le substrat 14 sur semelle conductrice d'électricité 13 est fixé comme précédemment dans un boîtier de blindage électromagnétique. Une embase coaxiale 10 est fixée contre la paroi 12 du boîtier de blindage et l'âme 16 de l'embase est engagée dans un logement 18 de cette paroi pour être reliée au circuit électronique. Le logement 18 est obtenu par perçage. Comme représenté en figure 4 qui est une vue de la face arrière de l'embase 10, celle-ci présente une surface de masse à proximité de l'âme 16 isolée par une gaine 17. Cette gaine 17 est par exemple en Téflon.

Selon l'invention, le contact de masse entre l'embase 10 et la semelle 13 est réalisé par l'intermédiaire d'une bague 30 conductrice d'électricité disposée coaxialement par rapport à l'âme 16, isolée de l'âme 16 et simultanément en contact électrique avec la surface de masse de l'embase 10 et la semelle 13 lorsque l'embase 10 est fixée contre la paroi 12. Sur la figure 4, la position de la bague 30 est représentée en traits discontinus.

On réalise ainsi un prolongement de la masse de l'embase 10, à travers la paroi 12, jusqu'à la semelle 13. Le chemin de masse est réduit au maximum et le contact électrique est optimal. L'embase 10 n'est pas nécessairement en contact avec la paroi 12. Comme dans l'état de la technique, l'âme 16 peut être directement soudée sur une piste du substrat 14.

Dans le mode de réalisation de la figure 3, la bague 30 peut être en un matériau tel que l'aluminium ou le laiton et sa longueur est calculée de telle sorte qu'un bon contact soit établi par déformation de la semelle en laiton.

Il est également possible d'utiliser une bague présentant une élasticité et de la réaliser à partir d'un matériau synthétique chargé de métal. On exploite alors l'élasticité de la bague pour assurer un contact de masse optimal.

Dans un autre mode de réalisation, représenté à la figure 5, la bague 30 coopère avec une rondelle 50 élastique disposée coaxialement par rapport à l'âme 16, entre la surface de masse de l'embase 10 et la bague 30. Afin d'assurer une continuité de masse, la rondelle 50 et la bague 30 doivent être conducteurs d'électricité.

La rondelle 50 a par exemple une forme en S ou en cuvette. L'élasticité de la rondelle 50 permet de tolérer un jeu de positionnement entre la semelle 13 et la paroi 12, la distance séparant le circuit électronique de la paroi 12 étant habituellement de l'ordre de 0,1 mm. En dimensionnant correctement les différents éléments, après serrage des vis 11, la rondelle 50 est presque entièrement aplatie entre l'embase 10 et la bague 30.

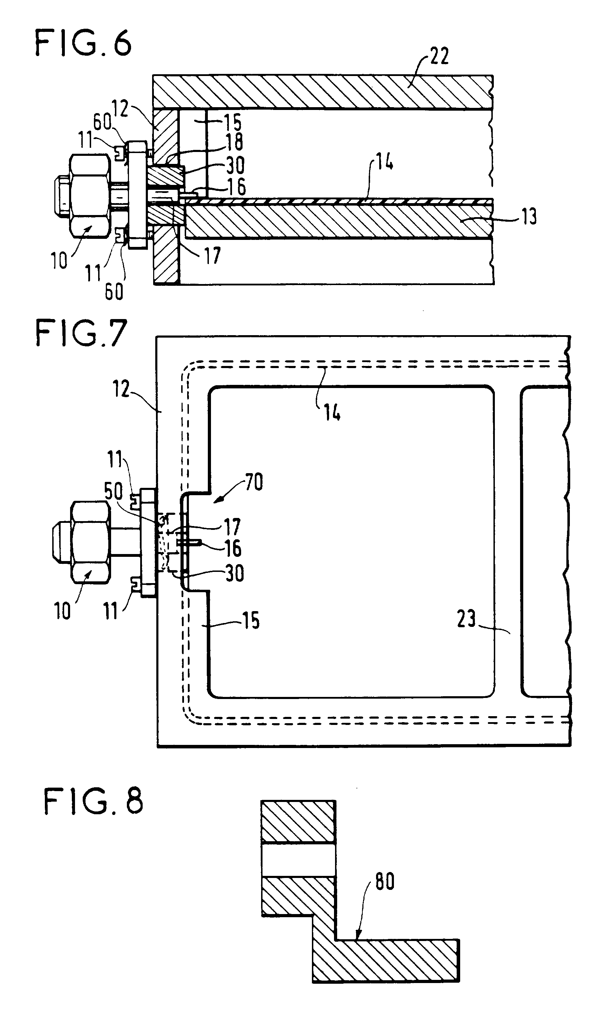

Dans un troisième mode de réalisation, représenté à la figure 6, chaque vis 11 de fixation de l'embase 10 contre la paroi 12 coopère avec une rondelle élastique 60. Le nombre de vis est habituellement de quatre et on obtient le même effet qu'avec le montage de la figure 5.

Il est à noter que les montages des figures 5 et 6 sont particulièrement adaptés aux milieux où les éléments utilisés peuvent changer de dimensions, par exemple se dilater. L'utilisation d'éléments élastiques permet de tenir compte de ces changements et d'assurer constamment un contact de masse optimal.

La figure 7 est une vue de dessus d'une partie d'un boîtier de blindage non recouvert par un couvercle tel que 22 (fig.2), où le dispositif de liaison électrique faisant également l'objet de l'invention est du type représenté à la figure 5.

Le socle du boîtier de blindage comporte le trottoir 15 contre lequel est fixé, à l'aide de vis, le substrat 14. Au niveau de l'embase 10, le trottoir 15 présente une échancrure 70 au niveau du logement réalisé dans la paroi 12 pour permettre l'accès à la ligne microstrip présente sur le substrat 14. On voit sur cette figure la constitution du socle dans lequel sont réalisés les cloisons de séparation des fonctions électroniques haute-fréquence, telle que 23.

Il est également possible de réaliser des embases comprenant d'origine une prolongation formant bague, isolée de l'âme.

Concernant les matériaux utilisés, la semelle du circuit électronique peut être en laiton, en cuivre ou en aluminium et la bague est préférentiellement en laiton ou en aluminium. La longueur de cette bague est à titre d'exemple de l'ordre de 3,5 mm et son diamètre de 2,2 ou 4,15 mm, selon l'embase utilisée, afin de conserver l'impédance caractéristique.

La figure 8 est une vue en coupe d'un autre mode de réalisation d'une bague pouvant être utilisée dans la présente invention.

Cette bague présente un méplat 80 destiné à permettre la soudure de la bague sur la semelle du circuit électronique présent dans le boîtier. Le contact électrique de masse est ainsi encore amélioré.

## Revendications

1. Système de liaison électrique entre un circuit électronique réalisé sur un substrat (14) sur semelle conductrice d'électricité (13) fixé dans un boîtier de blindage électromagnétique et une embase coaxiale (10) fixée contre une paroi externe (12) dudit boîtier de blindage, l'âme (16) de ladite embase (10) étant engagée dans un logement (18) de ladite paroi (12) pour être reliée audit circuit électronique, ladite embase (10) présentant une surface de masse située en face de ladite paroi (12),
caractérisé en ce que le contact de masse entre ladite embase (10) et ladite semelle (13) est réalisé par l'intermédiaire d'une bague (30) conductrice d'électricité disposée coaxialement par rapport à ladite âme (16), isolée de ladite âme (16) et simultanément en contact électrique avec ladite surface de masse de ladite embase (10) et ladite semelle (13) lorsque ladite embase (10) est fixée contre ladite paroi (12) dudit boîtier.

2. Système selon la revendication 1, caractérisé en ce que ladite bague (30) coopère avec une rondelle (50) élastique conductrice d'électricité disposée coaxialement par rapport à ladite âme (16), entre ladite surface de masse et ladite bague (30).

3. Système selon la revendication 1, caractérisé en ce que ladite bague (30) présente une élasticité.

4. Système selon la revendication 3, caractérisé en ce que ladite bague (30) présentant une élasticité est en un matériau synthétique chargé de métal.

5. Système selon la revendication 1, caractérisé en ce que ladite embase coaxiale (10) est fixée à l'aide de vis (11) contre ladite paroi (12) dudit boîtier et en ce que chacune desdites vis (11) coopère avec une rondelle élastique (60).

6. Système selon l'une des revendications 1 à 5, caractérisé en ce que ledit boîtier présente un trottoir (15) contre lequel est fixé ledit substrat (14), ledit trottoir (15) présentant une échancrure (70) au niveau dudit logement (18) de ladite paroi (12) pour permettre l'accès à la ligne microstrip d'accès dudit circuit électronique.

7. Système selon l'une des revendications 1 à 6, caractérisé en ce que ladite bague présente un méplat (80) destiné à être soudé sur ladite semelle (13).

8. Dispositif de liaison électrique, pour utilisation dans un système de liaison électrique selon l'une des revendications 1 à 7, du type constitué par une embase coaxiale (10) présentant une âme (16) et une surface de masse, caractérisé en ce qu'il comprend une bague (30) conductrice d'électricité isolée de ladite âme (16) et disposée coaxialement par rapport à ladite âme (16).

## Patentansprüche

1. System zur elektrischen Verbindung zwischen einer elektronischen Schaltung, die auf einem von einer elektrische leitenden Basisplatte (13) getragenen Substrat (14) ausgeführt ist und in einem elektromagnetischen Abschirmgehäuse befestigt ist, und einer koaxialen Steckverbindung (10), die an einer Außenwand (12) dieses Abschirmgehäuses befestigt ist, wobei der Innenleiter der Steckverbindung in einen Raum (18) der Wand (12) eingesteckt ist, um mit der Elektronikschaltung verbunden zu werden, wobei die Steckverbindung (10) eine Massefläche aufweist, die vor dieser Wand (12) angeordnet ist,
dadurch gekennzeichnet, daß der Massekontakt zwischen der Steckverbindung (10) und der Basisplatte (13) mittels eines elektrisch leitenden Rings (30) hergestellt wird, der koaxial in Bezug auf den Innenleiter (16) angeordnet ist, gegen diesen Innenleiter (16) isoliert ist und gleichzeitig in elektrischem Kontakt mit der Massefläche der Steckverbindung (10) und der Basisplatte (13) steht, wenn die Steckverbindung (10) an der Wand (12) des Gehäuses befestigt ist.

2. System nach Anspruch 1, dadurch gekennzeichnet, daß der Ring (30) mit einer elektrisch leitenden Federscheibe (50) zusammenwirkt, die koaxial in Bezug auf den Innenleiter (16) zwischen der Massefläche und dem Ring (30) angeordnet ist.

3. System nach Anspruch 1, dadurch gekennzeichnet, daß der Ring (30) eine Elastizität aufweist.

4. System nach Anspruch 1, dadurch gekennzeichnet, daß der elastische Ring (30) aus einem mit Metall angereicherten Kunststoffmaterial besteht.

5. System nach Anspruch 1, dadurch gekennzeichnet, daß die koaxiale Steckverbindung (10) mit Hilfe von Schrauben (11) an der Wand (12) des Gehäuses befestigt ist und jede Schraube (11) mit einer Federscheibe (60) zusammenwirkt.

6. System nach einem der Ansprüche 1 bis 5, dadurch gekennzeichnet, daß das Gehäuse einen überstehenden Rand (15) besitzt, an dem das Substrat (14) befestigt ist und der in Höhe des Raums (18) in der Wand (12) einen Ausschnitt (70) aufweist, um den Zugang zur Mikrostripleitung zur Elektronikschaltung zu erlauben.

7. System nach einem der Ansprüche 1 bis 6, dadurch gekennzeichnet, daß der Ring eine Abflachung (80) besitzt, die an die Basisplatte (13) gelötet werden kann.

8. Vorrichtung zur elektrischen Verbindung in einem System zur elektrischen Verbindung gemäß einem der Ansprüche 1 bis 7, die aus einer koaxialen Steckverbindung (10) besteht, die einen Innenleiter (16) und eine Massefläche aufweist, dadurch gekennzeichnet, daß sie einen vom Innenleiter (16) isolierten elektrisch leitenden Ring (30) aufweist, der koaxial in Bezug auf diesen Innenleiter (16) angeordnet ist.

## Claims

1. System for making an electrical connection between an electronic circuit implemented on a substrate (14) on an electrically conductive bottom plate (13) fixed into an electromagnetic shield box and a coaxial socket (10) fixed to an outside wall (12) of said shield box, the core (16) of said socket (10) being inserted in a hole (18) in said wall (12) in order to be connected to said electronic circuit, said socket (10) having an earthing surface facing said wall (12),
characterised in that the earthing contact between said socket (10) and said bottom plate (13) is made by way of an electrically conductive ring (30) coaxial with said core (16), insulated from said core (16) and simultaneously in electrical contact with said earthing surface of said socket (10) and said bottom plate (13) when said socket (10) is fixed to said wall (12) of said box.

2. System according to claim 1 characterised in that said ring (30) cooperates with an electrically conductive spring washer (50) coaxial with said core (16) between said earthing surface and said ring (30).

3. System according to claim 1 characterised in that said ring (30) is elastic.

4. System according to claim 3 characterised in that said elastic ring (30) is made from a synthetic material charged with metal.

5. System according to claim 1 characterised in that said coaxial socket (10) is fixed to said wall (12) of said box by screws (11) and each screw (11) cooperates with a spring washer (60).

6. System according to any one of claims 1 to 5 characterised in that said box has a flange (15) to which said substrate (14) is fixed and having a notch (70) at the location of said hole (18) in said wall (12) to provide access to the microstrip access line of said electronic circuit.

7. System according to any one of claims 1 to 6 characterised in that said ring has a flat (80) adapted to be soldered to said bottom plate (13).

8. Electrical connection device for use in an electrical connection system according to any one of claims 1 to 7, of the type comprising a coaxial socket (10) having a core (16) and an earthing surface, characterised in that it comprises an electrically conductive ring (30) insulated from said core (16) and coaxial therewith.
